(19) Europäisches Patentamt
European Patent Office
Office européen des brevets

(11) Publication number : 0 554 040 A2

(12) # EUROPEAN PATENT APPLICATION

(21) Application number : 93300536.5

(22) Date of filing : 26.01.93

(51) Int. Cl.$^5$ : **C08L 79/08,** G03F 7/075

(30) Priority : 27.01.92 JP 35670/92

(43) Date of publication of application :
04.08.93 Bulletin 93/31

(84) Designated Contracting States :
DE FR GB

(71) Applicant : SHIN-ETSU CHEMICAL CO., LTD.
6-1, Ohtemachi 2-chome
Chiyoda-ku Tokyo (JP)

(72) Inventor : Okinoshima, Hiroshige
No. 19-1, Isobe 3-chome
Annaka-shi, Gunma-ken (JP)
Inventor : Kato, Hideto
No. 179-5, Kaminamie-machi
Takasaki-shi, Gunma-ken (JP)

(74) Representative : Stoner, Gerard Patrick et al
Mewburn Ellis 2 Cursitor Street
London EC4A 1BQ (GB)

(54) **Photosensitive resin compositions, their preparation and use.**

(57) A photosensitive resin composition contains a polyimide precursor polymer comprising acid anhydride, silylated diamine and diamine units and a photosensitive diazoquinone. It is sensitive to light and shelf stable in solution form, and offers a resin coating which can be heat cured into a polyimide coating having improved adhesion, heat resistance and electrical and mechanical properties. The cured coating is a useful electronic part protective film.

EP 0 554 040 A2

This invention relates to photosensitive resin compositions. In particular, but not exclusively, suitable for forming protective insulating films for semiconductor elements, orienting films for liquid crystal display elements, insulating films for multilayer printed circuit boards and the like. It also relates to methods of preparing such compositions and to products, such as heat-resistant protective films for electronic parts, obtainable by curing them.

Prior Art

Heat-resistant photosensitive materials known in the art include a material comprising polyamic acid and dichromate (Japanese Patent Publication No. 17374/1974 or US-A-3,623,870), a material comprising polyamic acid having a photosensitive group introduced into its carboxyl group through an ester bond (Japanese Patent Application Kokai (JP-A)115541/1974 or US-A-3,957,512 and JP-A 45746/1980), a material comprising polyamic acid having a photosensitive group introduced into its carboxyl group through an amide bond (JP-A 100143/1985 or US-A-4,515,887 and US-A-4,587,204), a material comprising polyamic acid having a photosensitive group introduced into its carboxyl group through a silyl ester bond (JP-A 275129/1987), and a material comprising polyamic acid and an amine compound having a photosensitive group (JP-A 145794/1979 or US-A-4,243,743). These materials, however, suffer from such problems as the presence of ionic impurities (US-A-3,623,870 and US-A-3,957,512), film swelling during development (US-A-3,957,512, US-A-4,515, 887 and US-A-4,587,204), and unstable sensitivity (JP-A-275129/1987 and 145794/1979 or US-A-4,243,743).

To overcome these problems, positive photosensitive resin compositions comprising in admixture a polyimide resin having a phenolic group and a naphthoquinonediazidosulfonate were proposed in Polymer Engineering and Science, July 1989, Vol. 29, 954 and JP-A 115461/1991. This approach has to use a special base material and still suffers from the problem that a phenolic group is left after film formation.

A general problem addressed herein is to provide new and useful photosensitive resin compositions, together with methods of making and using them and products thereof.

In preferred aspects, problems addressed include (independently) the achieving of a material which is applicable to a wide variety of polyimide resin base materials, stable during shelf storage and easy to use, and cures into a film which has good adhesion as well as good thermal, electrical and mechanical properties, and is preferably suitable for protecting semiconductor elements and other electronic parts.

According to the present invention, there is provided a photosensitive resin composition comprising (A) a polymer comprising recurring units of the following general formulae (1), (2) and (3) and (B) a photosensitive diazoquinone compound.

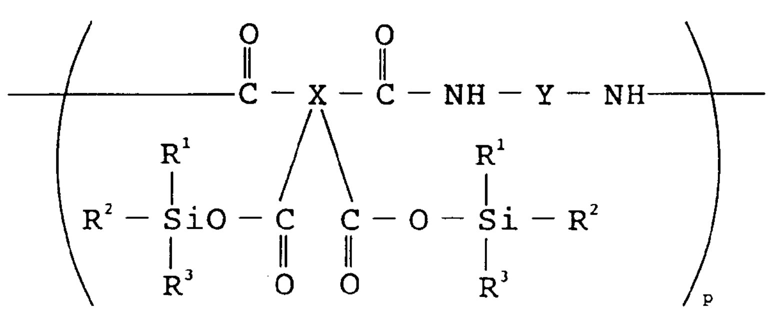

...(1)

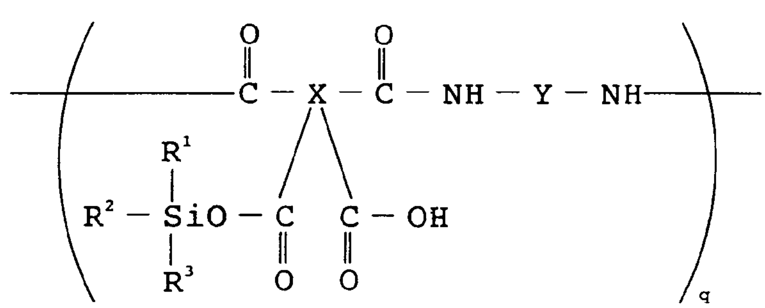

...(2)

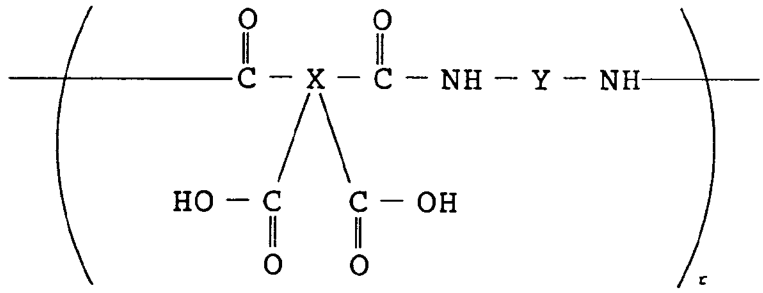

...(3)

In the formulae, X is a tetravalent organic group containing an aromatic or aliphatic ring,

Y is a divalent organic group,

$R^1$, $R^2$ and $R^3$ are independently a hydrogen atom or a monovalent organic group having 1 to 10 carbon atoms,

letters p, q and r are 0 or integers of at least 1 and satisfy the relationship: $0.2 \leqq (2p + q)/(2p + q + r) \leqq 1$.

By blending such components we have been able to prepare positive photosensitive compositions comprising a polyimide resin precursor and a photosensitive compound. These we found to be sensitive to light irradiation and thus easy to pattern. They allow for a choice among a wide variety of polyimide resin base materials on preparation, enable substantial freedom from mixed ionic impurities, and are stable on shelf storage and easy to apply. The resulting cured film is a polyimide film having good adhesion and improved thermal, electrical and mechanical properties and thus suitable as a protective film e.g. for electronic parts.

## DETAILED DESCRIPTION

According to the present invention, a photosensitive resin composition is defined as predominantly containing a polyimide precursor comprising recurring units of formulae (1), (2) and (3) as component (A).

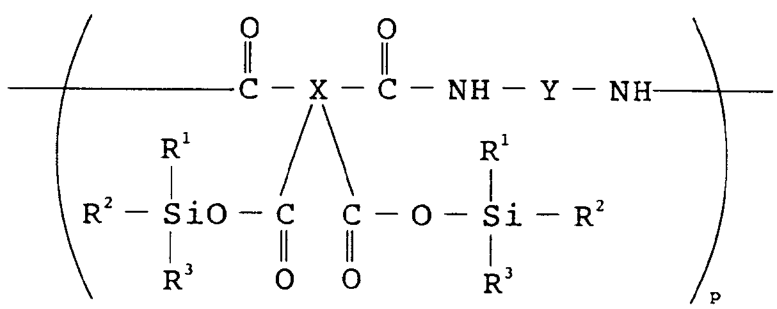

...(1)

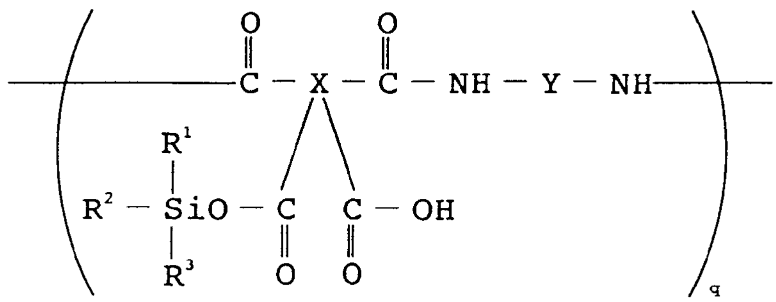

...(2)

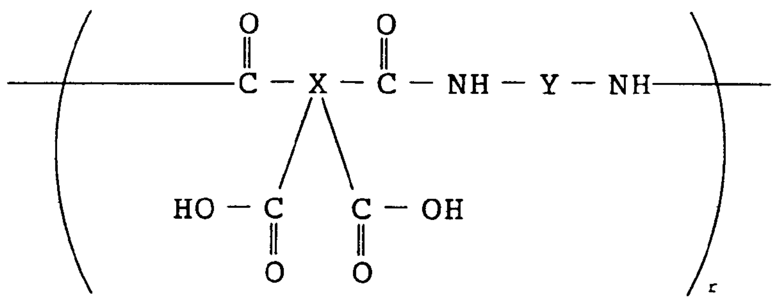

...(3)

In the formulae, X is a tetravalent organic group and Y is a divalent organic group, both being later described in more detail.

$R^1$, $R^2$ and $R^3$, which may be identical or different, are a hydrogen atom or a monovalent organic group having 1 to 10 carbon atoms, preferably 1 to 6 carbon atoms. Examples of the organic group include alkyl groups such as methyl, ethyl, propyl and butyl groups; alkenyl groups such as vinyl, allyl and butenyl groups; aryl groups such as phenyl and tolyl groups; and substituted ones of these groups in which some or all of the hydrogen atoms attached to carbon atoms are replaced by halogen atoms, cyano groups, alkoxy groups or the like, such as chloromethyl, chloropropyl, 3,3,3-trifluoro propyl, 2-cyanoethyl, methoxymethyl and ethoxyethyl groups.

$R^1$, $R^2$ and $R^3$ form a silyl group ($-SiR^1 \cdot R^2 \cdot R^3$), examples of which are given below though not limited thereto.

$-SiH(CH_3)_2$, $-Si(CH_3)_3$, $-Si(CH_3)_2 \cdot C_2H_5$, $-Si(CH_3)_2 \cdot CH{=}CH_2$ $-Si(C_2H_5)_3$,

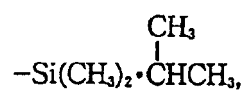

$-Si(CH_3)_2 \cdot C(CH_3)_3$, $-Si(CH_3)_2 \cdot C_6H_5$

In the recurring units (1) and (2), these silyl groups may be either identical or different. Often not more than one, or two, of the R's is H.

Letters p, q and r representing the number of recurring units (1), (2) and (3) are 0 or integers of at least 1 and satisfy the relationship: $0.2 \leqq (2p + q)/(2p + q + r) \leqq 1$. For better photosensitivity and shelf stability as well as film physical properties, we find that they should preferably satisfy the relationship: $0.5 \leqq (2p + q)/(2p + q + r) \leqq 1$ and $10 \leqq (p + q + r)$.

The polymers having recurring units (1), (2) and (3) may be synthesized in accordance with the method of JP-B 18790/1968, for example.

More specifically, the polymers may be synthesized by reacting a tetracarboxylic dianhydride of the general formula (4), a silylated diamine of the general formula (5) and a diamine of the general formula (6) in a suitable solvent e.g. so that the total moles of diamines of formulae (5) and (6) are approximately equal to the moles of dianhydride of formula (4). However, the polymer synthesis is not limited to this method.

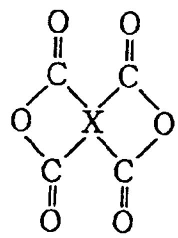

··· (4)

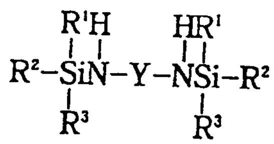

··· (5)

$H_2N-Y-NH_2$ (6)

X in formula (4) is a tetravalent organic group containing an aromatic or aliphatic ring. It is understood that X in recurring units (1), (2) and (3) in the polymer or component (A) is derived from the tetracarboxylic dianhydride of formula (4). Examples of X and the tetracarboxylic dianhydride are shown below. These compounds are very well known in that art for this purpose, and may be chosen from a very wide variety to give a suitable polyimide precursor. The ones listed here are the best known.

| X | Tetracarboxylic dianhydride |
|---|---|
| 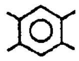 | pyromellitic dianhydride |
| 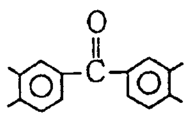 | benzophenonetetracarboxylic dianhydride |
| 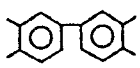 | 3,3',4,4'-biphenyltetra-carboxylic dianhydride |
| 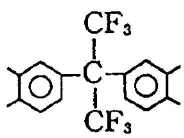 | 2,2-bis(3,4-benzene-dicarboxylic anhydride)-perfluoropropane |
| 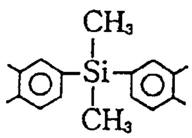 | bis(3,4-dicarboxyphenyl)-dimethylsilane dianhydride |
| 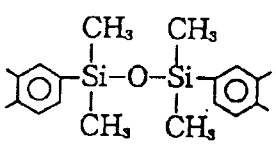 | 1,3-bis(3,4-dicarboxyphenyl)-1,1,3,3-tetra-methyldisiloxane dianhydride |
| 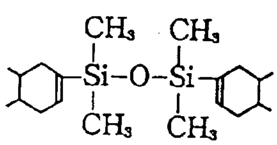 | 1,3-bis[4-(1,2,3,6-tetrahydrophthalic anhydride)]-1,1,3,3-tetramethyldisiloxane |
| 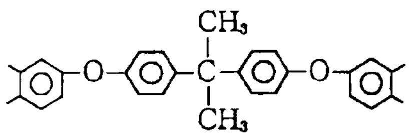 | 2,2-bis[4-(3,4-dicarboxyphenoxy)-phenyl]propane dianhydride |

The tetracarboxylic dianhydrides are not limited to these examples, and X may be one or a mixture of the foregoing members.

Y in formulae (5) and (6) is a divalent organic group. It is understood that Y in recurring units (1), (2) and

(3) in the polymer or component (A) is derived from the diamines of formulae (5) and (6).

$R^1$, $R^2$ and $R^3$ in the silylated diamine of formula (5) may be identical or different and are a hydrogen atom or a monovalent organic group having 1 to 10 carbon atoms. Examples of $R^1$, $R^2$ and $R^3$ and silyl group ($-SiR^1 \cdot R^2 \cdot R^3$ are as previously shown. Examples of Y in the silylated diamine of formula (5) are the same as those of Y in the diamine of formula (6) described below.

Illustrative, non-limiting examples of the diamine of formula (6) include aromatic ring-containing diamines, for example, p-phenylenediamine, m-phenylenediamine, 4,4'-diaminodiphenylmethane, 4,4'-diaminodiphenyl ether, 2,2'-bis(4-aminophenyl)propane, 4,4'-diaminodiphenyl sulfone, 4,4'-diaminodiphenyl sulfide, 1,4-bis(3-aminophenoxy)benzene, 1,4-bis(4-aminophenoxy)benzene, 1,4-bis(m-aminophenylsulfonyl)benzene, 1,4-bis (p-aminophenylsulfonyl)benzene, 1,4-bis(m-aminophenylthioether)benzene, 1,4-bis(p-aminophenylthioether)benzene, 2,2-bis[4-(4-aminophenoxy)phenyl]propane, 2,2-bis[3-methyl-4-(4-aminophenoxy)phenyl] propane, 2,2-bis[3-chloro-4-(4-aminophenoxy)phenyl]propane, 1,1-bis[4-(4-aminophenoxy)phenyl]ethane, 1, 1-bis[3-methyl-4-(4-aminophenoxy)phenyl]ethane, 1,1-bis[3-chloro-4-(4-aminophenoxy)phenyl]ethane, 1,1-bis [3,5-dimethyl-4-(4-aminophenoxy)phenyl]ethane, bis[4-(4-aminophenoxy)phenyl]methane, bis[3-methyl-4-(4-aminophenoxy)phenyl]methane, bis[3-chloro-4-(4-aminophenoxy)phenyl]methane, bis[3,5-dimethyl-4-(4-aminophenoxy)phenyl]methane, bis[4-(4-aminophenoxy)phenyl]sulfone, 2,2-bis[4-(4-aminophenoxy)phenyl] perfluoropropane, etc.; diamines having a nuclearly substituted group in the form of an amide group as shown by the following formulae:

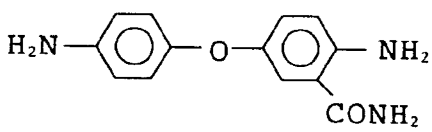 , 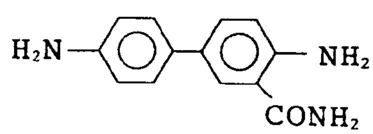 ;

and silicon diamines as shown below.

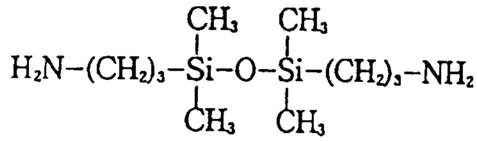 , 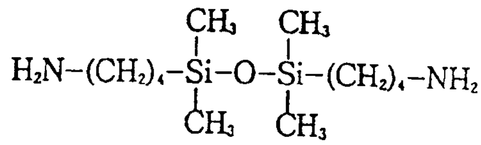 ,

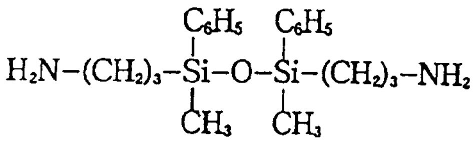 , 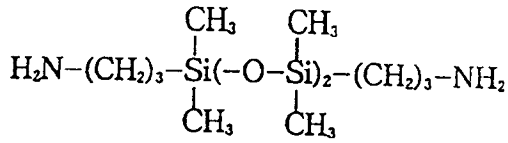 ,

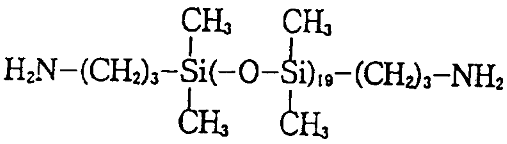 ,

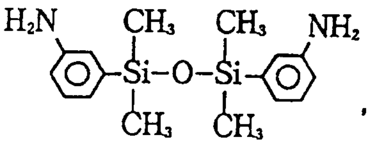 , 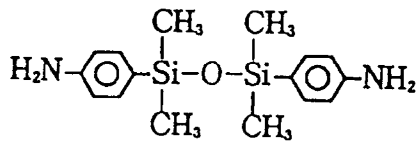 ,

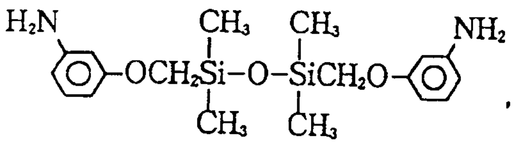 ,

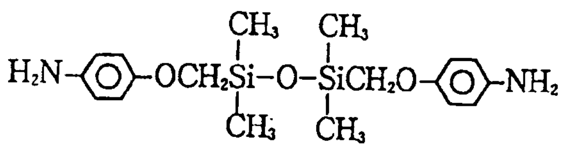 ,

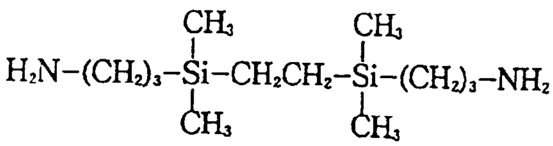 ,

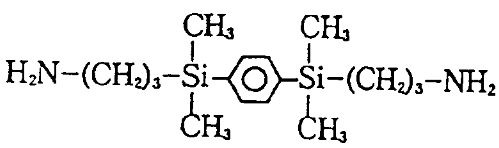

These diamines may be used either alone or in admixture of two or more. Therefore, Y in the recurring units of formulae (1), (2) and (3) constituting the polymer or component (A) may be either identical or different.

As with the dianhydrides, the skilled man is able to choose from a very wide variety of suitable diamines, and types of diamines, known to be suitable for making polyimide precursors in this technical context.

Component (B) of the photosensitive resin composition is a photosensitive diazoquinone compound. Typical of the photosensitive diazoquinones are O-naphthoxydiazidosulfonates and O-naphthoxydiazidosulfonamides. Especially preferred are O-naphthoxydiazidosulfonates of the following general formula (7):

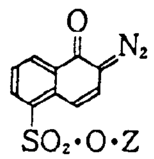 ... (7)

wherein Z is a monovalent organic group containing an aromatic ring. Examples of the O-naphthoxydiazidosulfonate of formula (7) are given below.

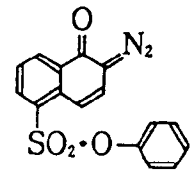 , 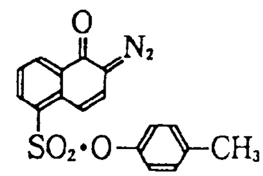

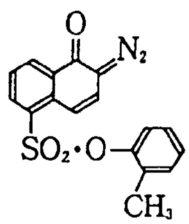 , 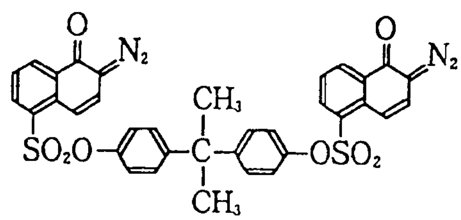 ,

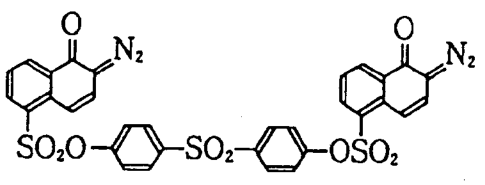 ,

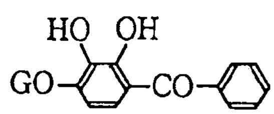 , 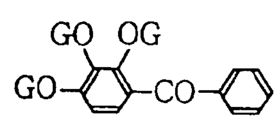

In the formulae, G is

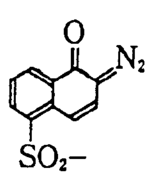 .

In preparing the photosensitive resin composition, photosensitive diazoquinone (B) may be blended with polymer (A) in any desired proportion. Preferably, 100 parts by weight of the polymer (A) is blended with about 2 to 100 parts, more preferably about 5 to 50 parts by weight of photosensitive diazoquinone (B).

Often the photosensitive resin composition is dissolved in a suitable organic solvent to form a solution composition which experiences little increase of viscosity with the lapse of time and is thus improved in shelf stability.

The solvent used herein is preferably the same as used in the synthesis of polymer (A) or polyimide precursor. Exemplary solvents are N-methyl-2-pyrrolidone, dimethylacetamide, dimethylformamide, hexamethylphosphoramide, tetrahydrofuran, 1,4-dioxane, methyl cellosolve, butyl cellosolve, diglyme (diethylene glycol

dimethyl ether), diethylene glycol diethyl ether, triethylene glycol dimethyl ether, acetone, methyl ethyl ketone, methyl isobutyl ketone, cyclopentanone, cyclohexanone, γ-butyrolactone, butyl cellosolve acetate, toluene, xylene, alone and in admixture of two or more.

Preferably the solvent is added to the photosensitive resin composition such that the total concentration of polymer (A) and diazoquinone (B) is about 5 to 50% by weight.

In addition to essential components (A) and (B), the photosensitive resin composition may contain optional additives, for example, adhesion aids such as γ-aminopropyltriethoxysilane, surface active agents, sensitivity modifiers, etc. in necessary amounts.

The photosensitive resin composition dissolved in an organic solvent, that is, solution composition can be applied to any desired one of substrates or supports such as silicon wafers, metal, glass and ceramic plates, by conventional well-known techniques including spin coating, dipping and printing. After application, the coating is pre-baked at a temperature of about 30 to 180°C for several minutes to several hours by heating means such as a dryer or hot plate, thereby removing the majority of the solvent to leave a coating of the photosensitive resin composition. This coating is of positive type. Then a relief pattern may be obtained from the film, for example, by resting a mask on the film, exposing the film to radiation such as visible light or ultraviolet radiation for several seconds to several minutes, and thereafter, dissolving away the exposed portions with a developer. The developer which can be used herein is preferably an alkaline aqueous solution, for example, an aqueous solution of tetramethylammonium hydroxide.

The resin in the relief pattern left after development is still in the form of a polyimide precursor and is thus further heated for curing at a temperature of about 200 to 500°C, especially about 300 to 400°C for several ten minutes to several hours by heating means such as a dryer or electric oven, obtaining a patterned polyimide coating.

The photosensitive resin composition can be readily patterned in this way and resin coatings obtained after curing have enough thermal, mechanical and electrical properties to use as protective films for electronic parts. The electronic part protective films may find a wide variety of application and are typically those for semiconductor devices, for example, junction coat films, passivation films and buffer coating films on the surface of semiconductor elements (e.g., diodes, transistors, IC and LSI), α-radiation shielding films on LSI, interlayer insulating films for multilayer interconnections, conformal coatings on printed circuit boards, orienting films of liquid crystal display elements, and ion implantation masks.

## EXAMPLE

Examples of the present invention are given below by way of illustration and not by way of limitation.

First described is the synthesis of polymer or component (A) of the photosensitive resin composition.

### Reference Example 1

A flask equipped with a stirrer, thermometer, and nitrogen purge tube was charged with 16.11 grams (0.05 mol) of 3,3',4,4'-benzophenonetetracarboxylic dianhydride and 100 grams of N-methyl-2-pyrrolidone as a solvent. To the flask, a solution containing 16.51 grams (0.048 mol) of N,N'-bis(trimethylsilyl)-4,4'-diaminodiphenyl ether and 0.79 grams (0.002 mol) of 1,3-bis[3-(N-trimethylsilyl)aminopropyl]-1,1,3,3-tetramethyldisiloxane as the silylated diamine in 44 grams of N-methyl-2-pyrrolidone was added dropwise such that the temperature of the reaction system did not exceed 40°C. After the completion of addition, agitation was continued for a further 10 hours, obtaining a solution of polyimide precursor ( I ) having the following recurring units and having a viscosity of 4,500 centipoise.

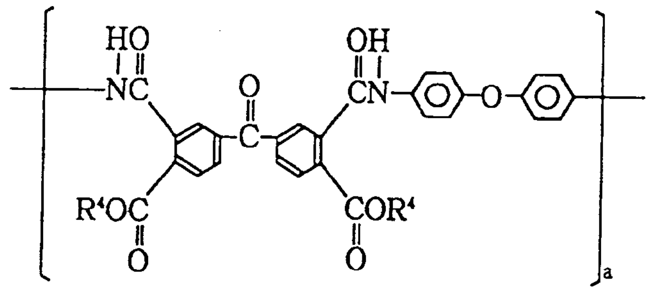

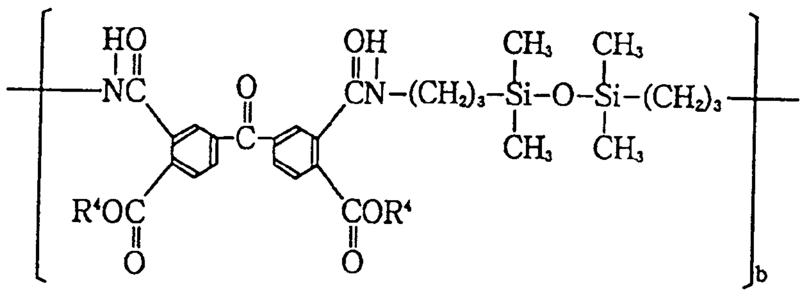

··· ( I )

$R^4 = -Si(CH_3)_3$, $a/b = 96/4$

## Reference Example 2

The procedure of Reference Example 1 was repeated using 22.2 grams (0.05 mol) of 2,2-bis(3,4-benzenedicarboxylic anhydride)perfluoropropane as the acid anhydride, 20.54 grams (0.048 mol) of N,N'-bis(t-butyldimethylsilyl)-4,4'-diaminodiphenyl ether and 0.79 grams (0.002 mol) of 1,3-bis[3-(N-trimethylsilyl)aminopropyl]-1,1,3,3-tetramethyldisiloxane as the silylated diamine, and 175 grams of diethylene glycol dimethyl ether as the solvent. There was obtained a solution of polyimide precursor ( II ) having the following recurring units and having a viscosity of 3,100 centipoise.

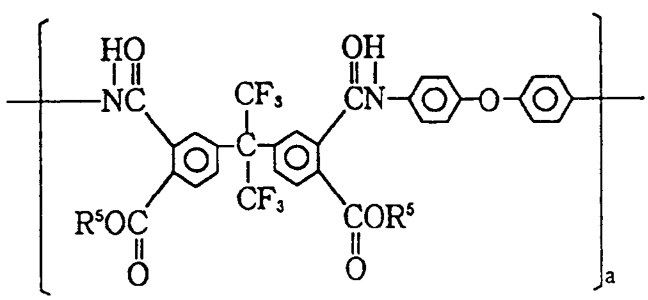

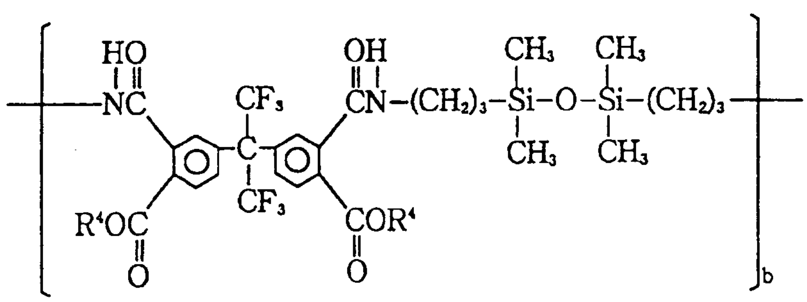

··· (II)

$R^4 = -Si(CH_3)_3$, $R^5 = -Si(CH_3)_2(C(CH_3)_3)$, $a/b = 96/4$

Reference Example 3

The procedure of Reference Example 1 was repeated using 14.50 grams (0.045 mol) of 3,3'-4,4'-benzophenonetetracarboxylic dianhydride and 2.13 grams (0.005 mol) of 1,3-bis(3,4-dicarboxyphenol)-1,1,3,3-tetramethyldisiloxane dianhydride as the acid anhydride, 8.60 grams (0.025 mol) of N,N'-bis(trimethylsilyl)-4,4'-diaminodiphenyl ether and 10.70 grams (0.025 mol) of N,N'-bis(t-butyldimethylsilyl)-4,4'-diaminodiphenyl ether as the silylated diamine, and 145 grams of γ-butyrolactone as the solvent. There was obtained a solution of polyimide precursor ( III ) having the following recurring units and having a viscosity of 3,800 centipoise.

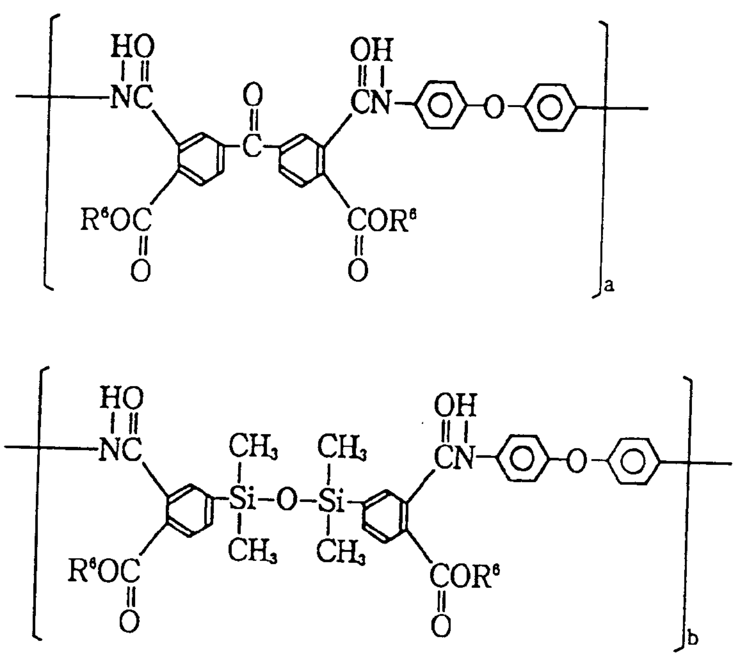

··· (III)

$R^6 = -Si(CH_3)_3 / -Si(CH_3)_2 = 50/50$, a/b = 90/10
$C(CH_3)_3$

Reference Example 4

The procedure of Reference Example 1 was repeated using 9.81 grams (0.045 mol) of pyromellitic dianhydride and 2.13 grams (0.005 mol) of 1,3-bis(3,4-dicarboxyphenyl)-1,1,3,3-tetramethyldisiloxane dianhydride as the acid anhydride, 17.06 grams (0.040 mol) of N,N'-bis(t-butyldimethylsilyl)-4,4'-diaminodiphenylmethane as the silylated diamine, 1.98 grams (0.010 mol) of 4,4'-diaminodiphenylmethane as the diamine, and 125 grams of N-methyl-2-pyrrolidone as the solvent. There was obtained a solution of polyimide precursor ( IV ) having the following recurring units and having a viscosity of 5,200 centipoise.

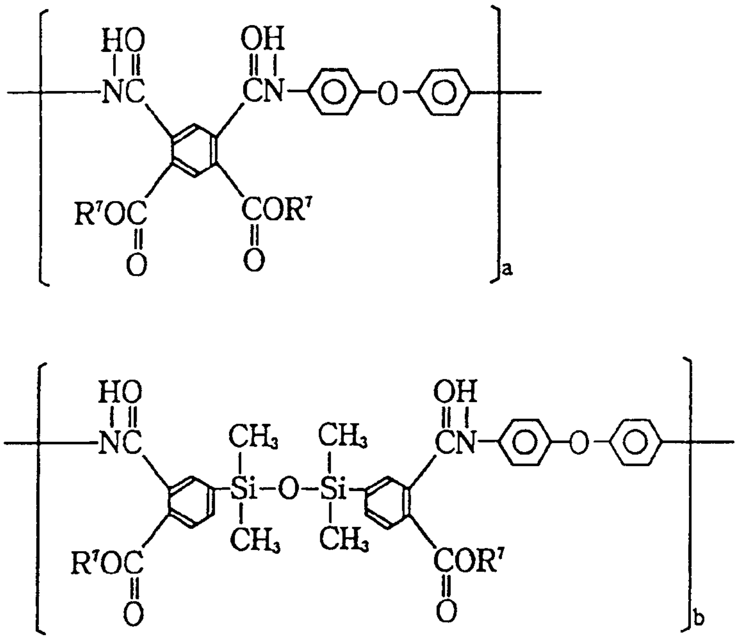

··· (IV)

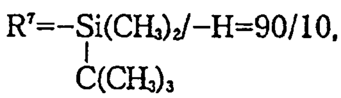 a/b = 90/10

Example 1 - 8

To the resin solutions obtained in Reference Examples 1 to 4 were added photosensitive diazoquinone and the solvent used in the respective resin solutions. In this way, solution compositions were prepared as shown in Table 1.

For evaluating shelf stability, the solution compositions were allowed to stand for three months at 5°C. The compositions were measured for viscosity both immediately after preparation and after aging, determining a change in viscosity from the initial.

The solution compositions were applied to silicon wafers by a spin coater and dried for one-half hour in a dryer at 80°C. A photo mask having a stripe pattern was closely rested on the coating, which was exposed to UV radiation from a 250-W ultra-high pressure mercury lamp for 20 seconds. The exposed coating was developed with a 2.3% aqueous solution of tetramethylammonium hydroxide and rinsed with pure water. The resulting line and space pattern was observed by examining its configuration and measuring the minimum line width. The coating was cured by heating at 200°C for 1 hour and then 350°C for 1/2 hour in a dryer. The cured coating was measured for thickness and examined for adhesion to the substrate by a Scotch tape test.

The results are shown in Table 1.

Table 1

| Example | Composition (pbw) | | | Shelf stability | Photosensitivity | | Adhesion | Cured film thickness (μm) |
|---|---|---|---|---|---|---|---|---|
| | Resin | Diazo-quinone | Solvent | Viscosity change 3-month/initial | Pattern | Resolution (μm) | Scotch tape test | |
| 1 | I (15) | α (4) | MP (81) | 1460 cp/ 1440 cp | Good | 5 | 100/100 | 1.3 |
| 2 | I (15) | β (4) | MP (81) | 1480 cp/ 1440 cp | Good | 4 | 100/100 | 1.1 |
| 3 | I (15) | γ (4) | MP (81) | 1490 cp/ 1440 cp | Good | 4 | 100/100 | 1.1 |
| 4 | II (15) | β (3) | diglyme (82) | 1040 cp/ 1030 cp | Good | 3 | 100/100 | 1.3 |
| 5 | II (15) | γ (3) | diglyme (82) | 1040 cp/ 1030 cp | Good | 3 | 100/100 | 1.3 |
| 6 | III (15) | β (3) | BL (82) | 1250 cp/ 1230 cp | Good | 4 | 100/100 | 1.5 |
| 7 | III (15) | γ (3) | BL (82) | 1260 cp/ 1230 cp | Good | 4 | 100/100 | 1.5 |
| 8 | IV (15) | β (4) | MP (81) | 1680 cp/ 1710 cp | Good | 6 | 100/100 | 2.1 |

The diazoquinones used in these examples are identified below.

α :

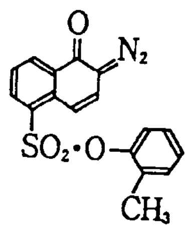

β :

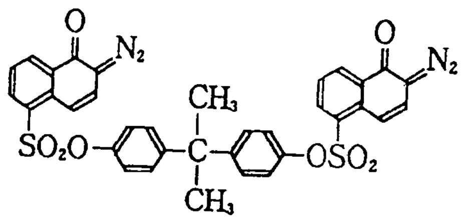

γ :

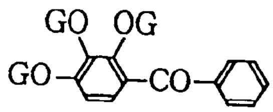

In the formulae, G is

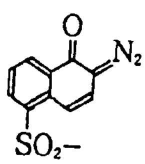

.

Solvents MP, diglyme, and BL are N-methyl-2-pyrrolidone, diethylene glycol dimethyl ether, and γ-butyrolactone, respectively.

In the Scotch tape test, 100/100 means that all the coating sections remained adhered, that is, no section was stripped.

It is evident from Table 1 that the solutions of the photosensitive resin compositions in Examples 1 to 8 (within the scope of the invention) are stable during shelf storage and well sensitive to light and cure to coatings capable of firm adhesion to silicone wafers. Thus the compositions are fully effective for forming protective films on electronic parts.

Since the dianhydrides and diamines used herein may be of generally known types, the present invention may be defined in a general aspect as providing a photosensitive resin comprising (A) a polyimide precursor having organosilyl-esterified polyamic repeat units, mixed with (B) photosensitive diazoquinone.

## Claims

**1.** A photosensitive resin composition comprising

(A) a polymer comprising recurring units of the following general formulae (1), (2) and (3):

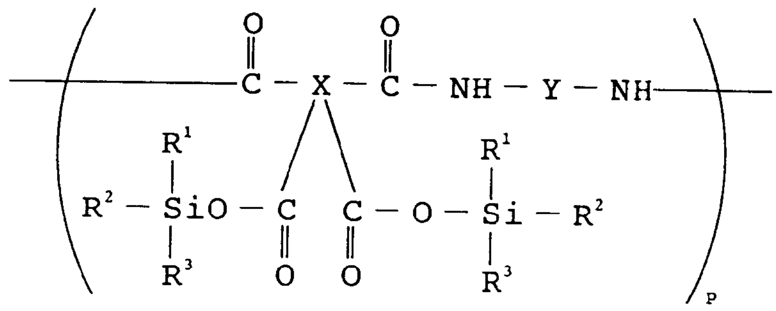

• • • (1)

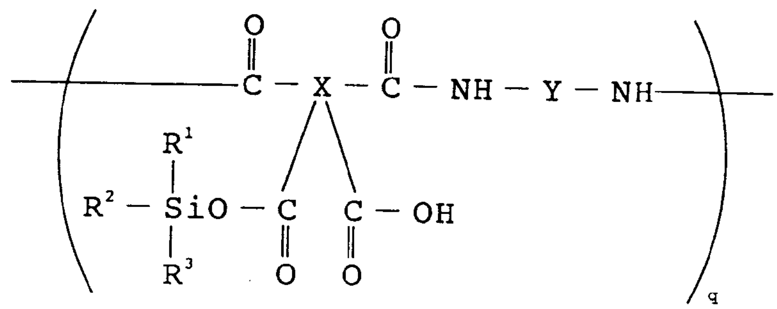

• • • (2)

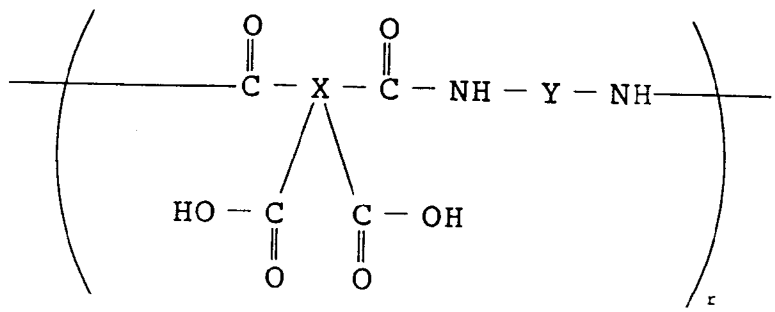

• • • (3)

wherein X is a tetravalent organic group containing an aromatic or aliphatic ring,
Y is a divalent organic group,
$R^1$, $R^2$ and $R^3$ are independently a hydrogen atom or a monovalent organic group having 1 to 10 carbon atoms,
letters p, q and r are 0 or integers of at least 1 and satisfy the relationship:
$0.2 \leqq (2p + q)/(2p + q + r) \leqq 1$, and
(B) a photosensitive diazoquinone compound.

**2.** A protective film for electronic parts obtained by curing a photosensitive resin composition as set forth in claim 1.

**3.** A method comprising the preparation of a composition according to claim 1.

**4.** A product comprising a cured composition according to claim 1.

**5.** A method of using a composition according to claim 1 in which the composition is applied, patterned by photoexposure and developing, and cured.